# EUROPEAN PATENT APPLICATION

(11) **EP 0 696 092 A2**
(43) Date of publication of application: **07.02.1996**
(21) Application number: 95111624.3
(22) Date of filing: 24.07.1995
(51) Int. Cl.: H01R 23/70

(54) **Arrangement for fixing connector**

(30) Priority: 01.08.1994 JP 180140/94
(71) Applicant: SUMITOMO ELECTRIC INDUSTRIES, INC., Chuo-ku, Osaka (JP); Sumitomo Wiring Systems, Ltd., Yokkaichi-shi Mie-ken (JP)
(72) Inventor: Hasegawa, Hiroshi, c/o Osaka Works, Konohana-ku, Osaka (JP); Okamura, Kenji, c/o Sumitomo Wiring Sys., Ltd., Yokkaichi-shi, Mie (JP)
(74) Representative: Schieschke, Klaus, Dipl.-Ing.

(57) **Abstract**

The feet provided at bottom of the housing of a surface-mounting connector are fastened to a circuit board with an adhesive. This solves the problems associated with conventional arrangements such as loosening of screws, poor fixing strength in press-fitted feet and extra step of soldering a fitting.

## Description

The present invention relates to an arrangement for fixedly mounting a surface-mounting connector to an on-board circuit board such as a printed circuit board.

A surface-mounting connector is mounted on a circuit board by fixing its housing to the circuit board. Then, its terminals mounted in the housing are soldered to conductors on the circuit board by heating in a reflow furnace.

When mounting the connector to the circuit board, it is required that the connector be positioned with high accuracy relative to the circuit board so that its terminals are connected reliably to the corresponding circuit conductors. It is also required that the connector be fixed in position with high strength in order to positively prevent its terminals from being detached from the conductors after soldering and to keep its housing stably fixed to the circuit board when a mating connector is inserted into or pulled out of the surface-mounting connector.

The former requirement, i.e. accurate positioning of the connector, is fulfilled by inserting pilot pin provided on the bottom of the connector housing into guide holes formed in the circuit board.

Conventional ways to fulfill the latter requirement, i.e. secure fixing of the connector, include 1) fixing the connector housing to the circuit board by means of screws, 2) press-fitting pins (which also serve as pilot pins) into holes formed in the circuit board, and 3) soldering metal fittings attached to feet or side of the housing to a metal pad provided on the circuit board.

Of these three fixing arrangements, the method 1) has a problem in that the screws can loosen easily because the on-board surface-mounting connector is vibrated rather violently. With the method 2), the connector can be fixed only very weakly. The method 3) requires extra step of attaching fittings to the connector. According to the mounting position of the fittings, it may be impossible to solder the fittings with an ordinary reflowing method in which farinfrared rays and hot air are used.

Moreover, if the fittings protrude from the housing, the area ratio of the connector on the circuit board will increase, thus reducing the mounting density on the circuit board.

An object of the present invention is to provide an arrangement for fixedly mounting a surface-mounting connector on a circuit board which can eliminate all the abovementioned problems.

According to the present invention, there is provided an arrangement for fixing an on-board surface-mounting connector to a circuit board, wherein the surface-mounting connector has a housing formed with feet on the bottom thereof, and wherein the surface-mounting connector is fixed to the circuit board by bonding the feet to said circuit board with an adhesive. The adhesive may be an age-setting adhesive, but a thermosetting adhesive is more desirable.

Since the connector is fixed to the circuit board with an adhesive, it will never loosen even if subjected to vibrations. Also, by bonding with an adhesive, the connector can be more securely fixed in position than by press-fitting pins. Moreover, the arrangement of the invention requires no fittings nor the step of attaching the fittings. Thus, the connector can be easily mounted on the circuit board.

If a thermosetting adhesive is used, it can be hardened with the heat produced during the reflowing treatment which is necessary to solder the terminals. Thus, it is possible to further shorten the time for mounting the connector to the circuit board.

Other features and objects of the present invention will become apparent from the following description made with reference to the accompanying drawings, in which:

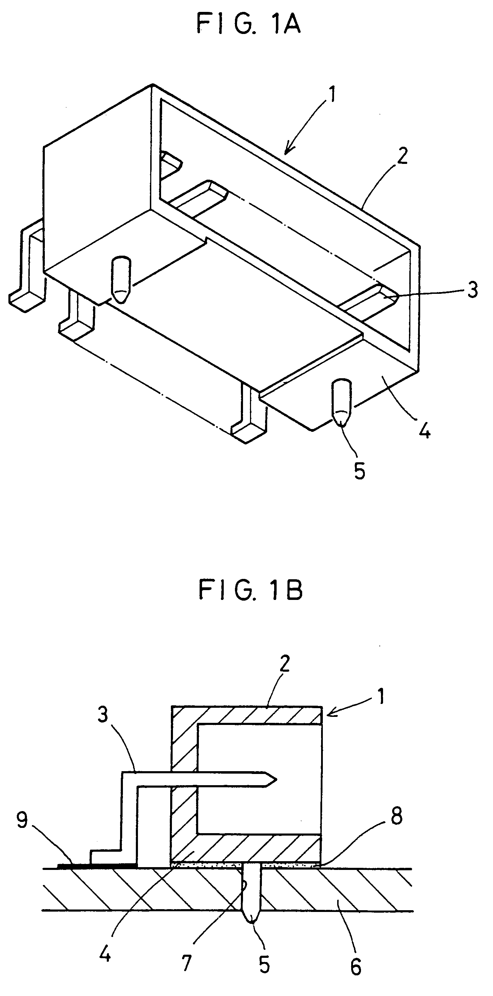

Fig. 1A is a perspective view of a surface-mounting connector to be fixed to a circuit board using the arrangement according to the present invention; and
Fig. 1B is a sectional view showing how the connector is fixed to the circuit board using the arrangement of the present invention.

Figs. 1A and 1B show an embodiment of the structure for fixing in position a surface-mounting connector according to the present invention. The surface-mounting connector 1 comprises a resin housing 2, and a plurality of terminals 3 arranged in the housing 2 at a predetermined pitch. The housing 2 is integrally formed with feet 4 on its bottom. A pilot pin 5 protrudes from each foot 4.

The connector 1 is held in position by inserting the pilot pins 5 into guide holes 7 formed in a circuit board 6 shown in Fig. 1B.

The feet 4 of the housing are placed on and fixed to the circuit board 6 with an adhesive 8 applied to the circuit board 6 only on the areas where the feet 4 are placed. The feet are fixed to the circuit board with the adhesive. After mounting the connector 1 on the circuit board 6, the circuit board is fed into a reflow furnace to solder the terminals 3 to conductors 9 on the circuit board 6.

The pilot pins 5, lightly press-fitted in the guide holes 7, serve as a temporary fastener for preventing the connector from shifting on the circuit board before the adhesive 8 hardens. The pins 5 may be replaced with feet which resist pulling forces once press-fitted (such as proposed by the applicant in Japanese Utility Model Application 5-1718).

For the abovementioned reason, the adhesive 8 should be a thermosetting type (such as epoxy).

It takes two seconds to apply adhesive for one connector, whereas it took about 10 seconds to fix one connector by conventional methods such as by screwing or by soldering fittings on the connector to a pad on the circuit board. Namely, with the arrangement of the present invention, it is possible to reduce the time taken to secure one connector to 1/5 compared to the conventional methods.

In another conventional method in which each connector is secured to a circuit board by press-fitting its feet, no extra steps and thus no extra time is needed to secure connectors. But with this method, the strength with which each connector is fixed is only less than 10 kgf, whereas with the arrangement of the present invention, it is possible to fix each connector with a strength of more than 20 kgf. Thus, connectors fixed in position by the method according to the present invention are much less likely to loosen due to vibrations. Also, they remain stably fixed to the circuit board when mating connectors are inserted into or pulled out of them.

According to the present invention, it is possible to securely mount a surface-mounting connector on a circuit board simply by fixing the feet formed on the housing to the circuit board with an adhesive. Thus, the connector can be mounted efficiently. Once mounted, its electrical connections are maintained with high reliability.

## Claims

1. An arrangement for fixing an on-board surface-mounting connector to a circuit board, wherein said surface-mounting connector has a housing formed with feet on the bottom thereof, and wherein said surface-mounting connector is fixed to said circuit board by bonding said feet to said circuit board with an adhesive.

2. An arrangement for fixing an on-board surface-mounting connector to a circuit board as claimed in claim 1, wherein said adhesive is a thermosetting type adhesive, and wherein said adhesive is hardened with the heat produced during reflowing.
